# EUROPEAN PATENT SPECIFICATION

(11) **EP 1 840 247 B1**
(45) Date of publication and mention of the grant of the patent: **04.06.2014**
(21) Application number: 07250520.9
(22) Date of filing: 08.02.2007
(51) Int. Cl.: C30B 11/12, C30B 29/06, C30B 29/60

(54) **Method of manufacturing silicon nanowires using porous glass template and device comprising silicon nanowires formed by the same**
Verfahren zur Herstellung von Siliziumnanodrähten mit einem porösen Glasmuster und Vorrichtung mit damit hergestellten Siliziumnanodrähten
Procédé de fabrication de nanofils en silicone utilisant un modèle de verre poreux et dispositif comportant des nanofils en silicone formés par celui-ci

(30) Priority: 29.03.2006 KR 20060028474
(43) Date of publication of application: 03.10.2007
(73) Proprietor: Samsung Electronics Co., Ltd., Suwon-si, Gyeonggi-do, 443-742 (KR)
(72) Inventor: Lee, Eun Kyung, Samsung Advanced Inst. of Technology, Suwon-si, Gyeonggi-do 449-712 (KR); Kwon, Soon Jae, Samsung Advanced Inst. of Technology, Suwon-si, Gyeonggi-do 449-712 (KR); Choi, Byoung Lyong, Samsung Advanced Inst. of Technology, Suwon-si, Gyeonggi-do 449-712 (KR); Cho, Kyung Sang, Samsung Advanced Inst. of Technology, Suwon-si, Gyeonggi-do 449-712 (KR); Lee, Jae Ho, Samsung Advanced Inst. of Technology, Suwon-si, Gyeonggi-do 449-712 (KR)
(74) Representative: Zijlstra, Robert Wiebo Johan

(56) References cited:
- EP-A2- 1 792 872
- WO-A1-2004/054924
- US-A1- 2003 121 882
- US-A1- 2003 185 985
- US-A1- 2005 253 138

## Description

The present invention relates, generally, to a method of manufacturing silicon nanowires using a porous glass template and a device comprising silicon nanowires formed using the method. More particularly, the present invention relates to a method of manufacturing silicon nanowires suitable for use in realizing a device and increasing the structural efficiency thereof, which is characterized in that silicon nanowires are formed and grown through an SLS (Solid-Liquid-Solid) process or a VLS (Vapor-Liquid-Solid) process using a porous glass template having nanopores doped with erbium or an erbium precursor, and a device comprising silicon nanowires formed using the method.

In general, nanowires are linear material having a diameter on the nanometer scale (1 nm = 10⁻⁹ m) and a length much larger than the diameter, for example, on the hundreds of nanometer, micrometer (1 µm = 10⁻⁶ m), or millimeter (1 mm = 10⁻³ m) scale. The properties of such nanowires depend on the diameter and length thereof.

The nanowires may be variously applied to minute devices due to their small size, and are advantageous because they exhibit optical properties of polarization or electron shift in a predetermined direction.

Presently, research into methods of preparing nanoparticles and into properties of the nanoparticles has been actively conducted. However, general methods of manufacturing nanowires are not well developed yet. Such methods typically comprise chemical vapor deposition (CVD), laser ablation, and a template process.

According to the template process, among the above-mentioned processes, pores having a size from ones of nanometers to hundreds of nanometers are formed, and such a pore is used as a nanowire template. For example, the template process includes oxidizing an aluminium electrode to form aluminium oxide on the surface thereof, electrochemically etching the aluminium oxide to form nanopores, dipping the electrode into a solution containing metal ions, applying voltage to stack the metal ions on the aluminium electrode through pores so that the pores are filled with the metal ions, and then removing the oxide using an appropriate process, thus obtaining only metal nanowires.

However, such a conventional method of manufacturing nanowires is disadvantageous because the process is considerably complicated and requires a long period of time, and is thus unsuitable for mass production. Further, it is impossible to form nanowires having excellent linearity and arrangement.

Although silicon, having an indirect band gap, is generally difficult to use as optical material, an electro-optic technique using silicon at room temperature may be realized through a combination of a technique of manufacturing a nano-device, capable of having a quantum effect, and a doping technique using luminescent material. To this end, the development of a doping technique enabling efficient luminescence and a technique able to decrease the size of the device to the nanoscale is required.

Since erbium (Er) has an emission peak at 1.54 µm, resulting in minimum loss in wavelength ranges used for optical communication, it is receiving attention as material for use in a silicon-based electro-optic devices. Moreover, the luminous properties of the device may be greatly improved by the energy from the excitons of silicon nanowires or silicon nanocrystals.

With regard to the method of manufacturing a photonic device using erbium, a method of manufacturing a silicon-based photonic device by doping silicon nanowires formed on a silicon substrate with erbium has been disclosed (Korean Patent Laid-open Publication No. 2005-103023). However, the above patent suffers because a process comprising use of a porous glass template upon the preparation of the nanowires is not disclosed, and this method can be applied only to photoluminescent devices.

In addition, there is disclosed a method of manufacturing a nano-dot array (Korean Patent Laid-open Publication No. 2003-056328) comprising forming an etching mask on a silicon film doped with erbium using a template having holes and then etching the exposed film portion to remove it. However, this method has a limitation because it forms nanowires via an etching process, rather than growing nanowires.

Accordingly, the present invention has been made keeping in mind the above problems occurring in the related art, and an object of the present invention is to provide a method of manufacturing silicon nanowires suitable for use in realizing a device and increasing the structural efficiency thereof by forming and growing silicon nanowires through an SLS process or a VLS process using a porous glass template.

Another object of the present invention is to provide a device comprising silicon nanowires formed along pores in a porous glass template.

The above and other objects, features and other advantages of the present invention will be more clearly understood from the following detailed description taken in conjunction with the accompanying drawings, in which:
FIG. 1 is a schematic view showing a principle of manufacturing silicon nanowires using a porous glass template according to the present invention;
FIG. 2 is a schematic view showing a process of manufacturing silicon nanowires through SLS;
FIG. 3 is a schematic view showing a process of manufacturing silicon nanowires through VLS;
FIG. 4 is a schematic view showing a principle of improving the luminous efficiency of the silicon nanowires of the present invention; and
FIG. 5 is a schematic view showing an electroluminescent device according to the present invention.

Hereinafter, a detailed description will be given of the present invention, with reference to the appended drawings.

According to the present invention, the method of manufacturing silicon nanowires is characterized in that silicon nanowires are formed and grown through an SLS process or a VLS process using a glass template having nanopores.

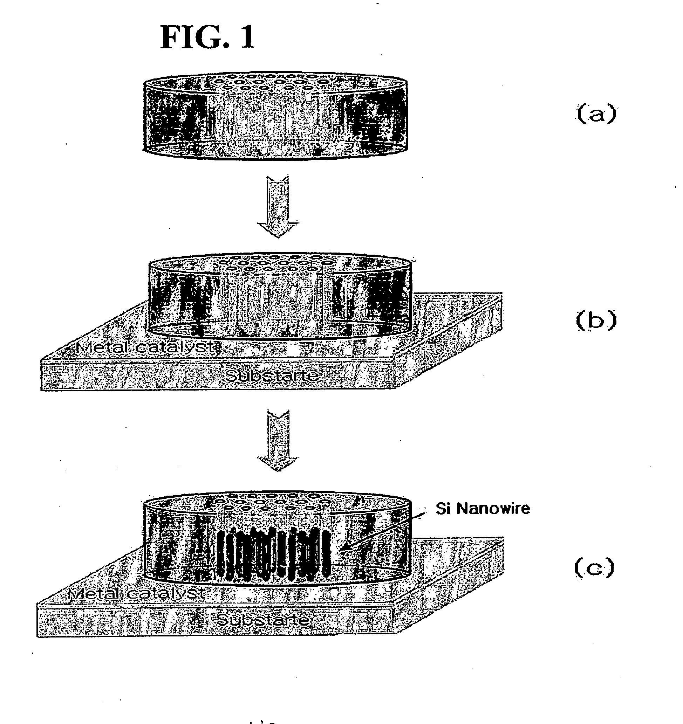

FIG. 1 is a schematic view showing a principle of manufacturing silicon nanowires using a porous glass template according to the present invention.

As shown in FIG. 1, the method of the present invention comprises steps of (a) doping a porous glass template with erbium or an erbium precursor to exhibit conductivity, (b) disposing the glass template doped with the erbium or erbium precursor on a substrate on which a metal catalyst layer is formed, and (c) forming and growing silicon nanowires along the pores in the glass template using an SLS process or a VLS process.

In the present invention, when the silicon nanowires are formed through the SLS process or the VLS process using the porous glass template, the diameter and length of the silicon nanowires may be easily controlled. In addition, the silicon nanowires may be formed into a superlattice structure or a hybrid structure by changing the material or composition thereof. In addition, doped silicon nanowires may be formed via a doping process using a dopant at the time of growth of the silicon nanowires.

Individual steps of the manufacturing method of the present invention are specifically described.

### (a) Doping Porous Glass Template with Erbium or Erbium Precursor

In order to manufacture the silicon nanowires according to the present invention, a porous glass template including a plurality of long wire-shaped pores is used.

Conventionally, as a template for the formation of nanowires, AAO (Anodic Aluminium Oxide) has been mainly used. However, since the size and length of pores are controlled depending on the applied voltage, the pores of the above template are difficult to form at a desired position. Further, in the case where the template is not completely etched in a longitudinal direction to form pores, the portion in which the pores are not formed must be removed, and therefore the process becomes complicated. Furthermore, since the melting point of aluminium present in the template is 660°C, the wires cannot be formed through the SLS process, which requires high temperatures. Moreover, the material is opaque, and thus cannot be applied to the fabrication of photonic devices.

In contrast, since the glass template used in the present invention is made by bundling fibers having large pores and then elongating them at one time, it is easy to uniformly form pores at a desired position. Additionally, since the length of the template is determined by the extent to which the fibers are cut, the template having uniform pores may be formed to various lengths. In addition, the process is simple and the melting point of glass is 1700°C, and thus the wires may be formed through the SLS process at high temperatures. Further, since the material is transparent, it may be applied to photonic devices, and furthermore, optical fiber techniques, which have been conventionally studied, may be employed.

Since the diameter and height of the porous glass template characteristically used in the present invention can be freely controlled, they may be selected depending on the size of the substrate on which the silicon nanowires are grown. Preferably, the diameter of the template ranges from 1 nm to 1 mm and the height thereof ranges from 100 nm to 1 mm, but the present invention is not limited thereto. Further, as for the variation in pores in the porous template, corresponding to the dimension of silicon nanowires to be manufactured, the pores are formed to a diameter ranging from 1 to 100 nm and at intervals ranging from 2 nm to 1 µm.

The process of doping the porous glass template with erbium or an erbium precursor is not particularly limited so long as it does not inhibit the purpose of the present invention, and a typical process in the art, for example, ion implantation, in which erbium is implanted using energy of the order of MeV and is then heat treated to minimize loss in the glass, electrochemical deposition, spin-on doping, chemical deposition, sputtering, laser ablation, co-precipitation, a wet process, or a sol-gel process, may be applied.

As the erbium precursor, erbium chloride (ErCl₃) may be used.

### (b) Disposing Doped Glass Template on Substrate Having Metal Catalyst Layer formed Thereon

After the formation of the glass template doped with erbium, such a glass template is disposed on the substrate on which a metal catalyst layer is formed. In the present invention, the metal catalyst layer is formed by coating a substrate with a metal catalyst, for example, a gold (Au) metal catalyst. As such, the substrate may be previously washed using a typical process to remove impurities.

The substrate usable in the present invention is exemplified by a silicon substrate or a glass substrate coated with silicon.

As the metal catalyst able to be applied on the substrate, any metal may be used so long as it enables growth of the wire. Examples of the metal include, but are not limited to, Au, Ni, Fe, Ag, Pd, and Pd/Ni, Pd/Au.

The metal catalyst may be applied on the substrate in the form of nanoparticles or a thin film, and the metal catalyst coating layer is preferably applied on the substrate to a thickness of 50 nm or less.

The process of applying the metal catalyst on the substrate is not particularly limited so long as it does not inhibit the purpose of the present invention, and a typical coating process used in the art, for example, CVD, sputtering, e-beam evaporation, vacuum deposition, spin coating, or dipping, may be used.

### (c) Forming and Growing Silicon Nanowires along Pores in Template through SLS or VLS

In the present invention, the silicon nanowires are formed using the SLS process or the VLS process.

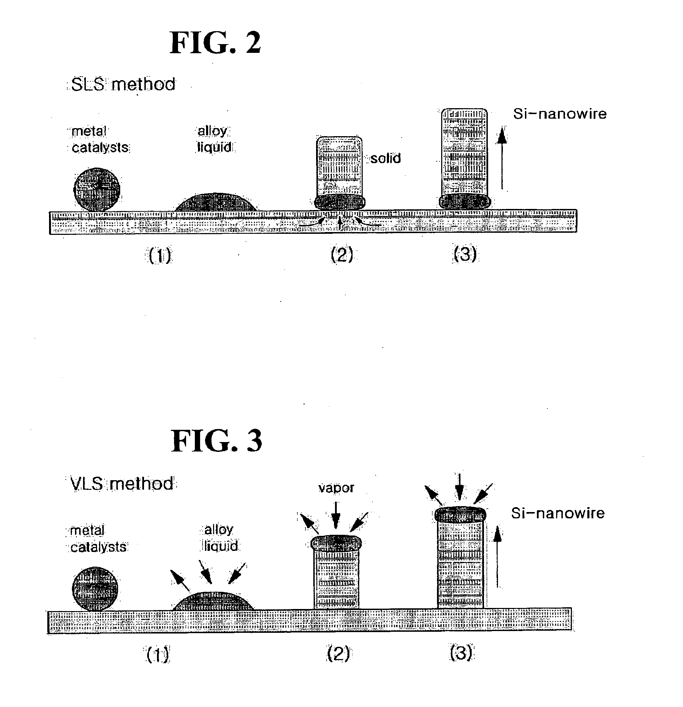

As shown in FIG. 2, the SLS process is conducted in a manner such that silicon diffused from the silicon substrate as a solid substrate is condensed and crystallized on the surface of a molten catalyst without the additional supply of vapor silicon, and is thus grown into silicon nanowires.

As shown in FIG. 3, the VLS process is conducted in a manner such that vapor silicon-containing species introduced into a hot furnace are condensed and crystallized on the surface(or interface) of a molten catalyst, such as gold, cobalt, nickel, etc., and are thus grown into silicon nanowires.

Specifically, the SLS process of the present invention may be conducted by placing a substrate on which a template is disposed in a furnace, and then heating the substrate while supplying a gas, so that silicon nanowires are formed by a wire source diffused from the substrate.

The VLS process may be conducted by placing a substrate on which a template is disposed in a furnace, and then heating the substrate while supplying a gas and a wire source, thereby forming silicon nanowires.

More specifically, the gas used in the SLS process or VLS process is selected from the group consisting of Ar, N₂, He and H₂, but is not limited thereto. Although the gas may be supplied in an amount of 100 sccm, it may vary depending on the process.

The SLS process is conducted at 800~1200°C under 1.0 bar (760 torr) or less, and the VLS process is conducted at 370~600°C under 1.0 bar (760 torr) or less in case of using gold catalyst. The heating time may be adjusted depending on the length of the silicon nanowires.

In the VLS process, the supplied wire source is exemplified by SiH₄, SiCl₄, or SiH₂Cl₂.

Further, upon the formation of the silicon nanowires in the present invention, silicon nanowires may be doped with a dopant, thus obtaining doped silicon nanowires. In addition, silicon nanowires may be formed into a superlattice structure or a hybrid structure by changing the material or composition thereof.

The silicon nanowire having the above structure is formed of material selected from the group consisting of III-V group compounds (e.g., gallium arsenide (GaAs), gallium nitride (GaN)), carbon nanotube (CNT), zinc oxide (ZnO), and silicon carbide (SiC).

In order to use the silicon nanowires thus formed without the glass template, the glass template may be removed using an etchant such as hydrofluoric acid.

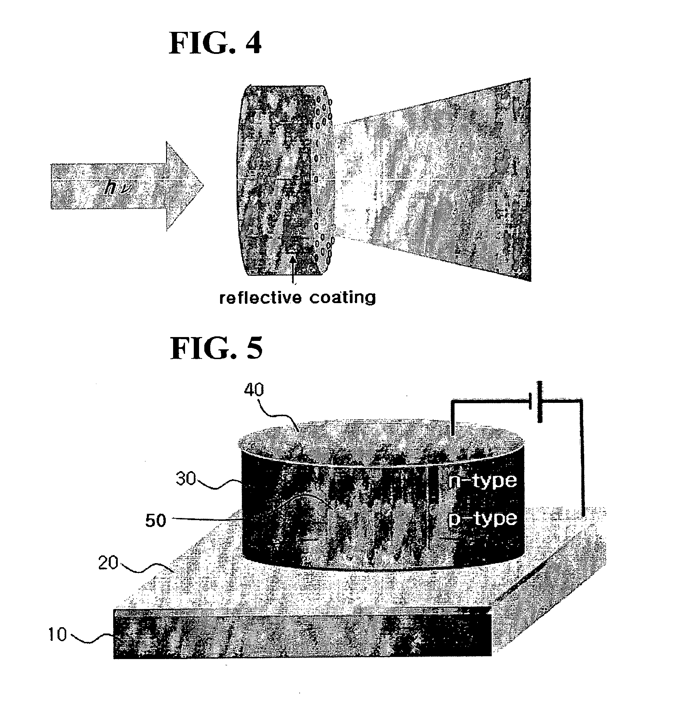

FIG. 4 is a schematic view showing a principle of improving the luminous efficiency of the silicon nanowires of the present invention. As shown in FIG. 4, the surface of the glass template, doped with erbium or an erbium precursor, is subjected to reflective coating, thereby increasing the luminous efficiency thereof. That is, in the presence of glass, light produced by erbium ions may be scattered in every direction. At this time, when material having high reflectivity or a layer of DBR (Distributed Bragg Reflector) is deposited on the wall surface or bottom surface to increase the reflectivity thereof, light which contacts the surface-treated portion as above is not externally emitted, leading to total internal reflection. Accordingly, light is emitted only to the portion having no reflective film, thus forming a predetermined orientation or increasing luminous efficiency.

In addition, the present invention provides a device comprising silicon nanowires suitable for use in realizing, and increasing the structural efficiency of, a device using the above method.

Specifically, examples of the device include, but are not limited to, electronic devices such as FETs (Field Effect Transistors), sensors, photodetectors, light emitting diodes, laser diodes, electroluminescent (EL) devices, photoluminescent (PL) devices, and cathodoluminescent (CL) devices.

Below, the case of EL device is specifically explained.

FIG. 5 is a schematic view showing the EL device according to the present invention. As shown in FIG. 5, the device includes a substrate 10, a first electrode layer 20, nanowires 50 formed along pores in a porous template 30, and a second electrode layer 40. In FIG. 5, although the formation of the first electrode layer 20 on the substrate 10 is exemplified, it may be formed therebeneath.

Particularly, the silicon nanowires 50 are p-type, n-type or p-n-type doped to have diode properties. In addition, the substrate 10, the first electrode layer 20, and the second electrode layer 40 may be manufactured through a typical process using material used for EL devices.

Generally, in the case of EL devices using nanowires obtained through a typical process, it is difficult to ensure the linearity of grown nanowires, and spaces between the nanowires are filled with another material and then the electrode is formed, leading to a complicated process. However, when using the silicon nanowires formed through the method of the present invention, a glass template that is transparent in the visible light range is included, and therefore linearity is improved. Thereby, since coupling efficiency with an external photonic device is increased, the electrode may be easily formed as soon as the nanowires are formed. Hence, the luminescent device may be inexpensively manufactured using a simple process.

Further, the device including the silicon nanowires of the present invention can control the shape of silicon nanowire, and, as well, may be applied not only to PL devices but also to EL devices.

A better understanding of the present invention may be obtained in light of the following examples which are set forth to illustrate, but are not to be construed to limit the present invention.

### Example 1

### Manufacture of Silicon Nanowires (1)

Using a sputtering process, erbium (Er) was doped on a porous glass template having a diameter of 100 µm and a length of 1 µm, in which wire-shaped pores were formed to a diameter of 20 nm and at intervals of 40 nm.

The silicon substrate was treated with an organic cleaner and hydrofluoric acid to remove a naturally occurring oxide film, after which Au nanoparticles having a size of about 10 nm, available from Nippon Paint Co. Ltd., as a catalyst, were applied through spin coating, thus forming silicon nanowires.

Subsequently, in order to grow the silicon nanowires, the glass template doped with erbium was disposed on the substrate, after which the substrate was loaded into the furnace and then heated at a rate of 10~15°C per min while supplying argon (Ar) of 100 sccm at a pressure of 500 torr.

When the process temperature reached 1000°C, it was maintained for 30 min to grow the silicon nanowires. Thereafter, the temperature was slowly decreased to 700°C, and thus, the growth of the silicon nanowires was terminated.

### Example 2

### Manufacture of Nanowires (2)

Silicon nanowires were manufactured in the same manner as in Example 1, with the exception that erbium chloride (ErCl₃) was used as the dopant instead of erbium, and 4% SiH₄ gas of 100 sccm was further supplied as the wire source in addition to the Ar gas, and the process temperature was controlled to 400°C.

### Example 3

### Manufacture of EL device

The silicon nanowires manufactured in Example 1 were disposed on the glass substrate patterned with ITO, after which an electrode was formed using a photo process.

Subsequently, titanium (Ti) was deposited to a thickness of 20 nm on the silicon wire-disposed substrate on which the electrode was formed, and then gold (Au) was deposited to a thickness of 100 nm to form a cathode, thereby completing the EL device.

As described hereinbefore, the present invention provides a method of manufacturing silicon nanowires using a porous glass template and a device comprising the silicon nanowires formed using the method. According to the present invention, the shape of the silicon nanowires, that is, the diameter and length thereof, may be freely controlled by a simple and economic process, and silicon nanowires suitable for use in realizing a device and increasing the structural efficiency thereof may be manufactured. Thus, the silicon nanowires of the present invention may be effectively applied to various devices, such as electronic devices such as FETs, sensors, photodetectors, LEDs, laser diodes, etc.

Although the preferred embodiments of the present invention have been disclosed for illustrative purposes, those skilled in the art will appreciate that various modifications, additions and substitutions are possible.

## Claims

1. A method of manufacturing silicon nanowires, comprising steps of:
(a) doping a porous glass template having a plurality of long wire-shaped pores with erbium or an erbium precursor;
(b) disposing the glass template doped with the erbium or erbium precursor on a substrate on which a metal catalyst layer is formed; and
(c) forming and growing silicon nanowires along the pores in the glass template.

2. The method as set forth in claim 1, wherein the porous glass template has a diameter ranging from 1 nm to 1 mm and a height ranging from 100 nm to 1 mm.

3. The method as set forth in either claim 1 or 2, wherein the pores of the porous glass template have a diameter ranging from 1 to 100 nm, and are formed at intervals ranging from 2 nm to 1 µm.

4. The method as set forth in any of claims 1 to 3, wherein the doping with the erbium or erbium precursor in step (a) is conducted using any process selected from the group consisting of ion implantation, electrochemical deposition, spin-on doping, chemical deposition, sputtering, laser ablation, coprecipitation, a wet process, and a sol-gel process.

5. The method as set forth in any of claims 1 to 4, wherein the erbium precursor used in step (a) is erbium chloride (ErCl₃) .

6. The method as set forth in any of claims 1 to 5, further comprising subjecting a surface of the glass template to reflective coating, after step (a).

7. The method as set forth in any of claims 1 to 6, wherein the substrate used in step (b) is a silicon substrate or a glass substrate coated with silicon.

8. The method as set forth in any of claims 1 to 7, wherein the metal catalyst used in step (b) is selected from the group consisting of Au, Ni, Fe, Ag, Pd, and Pd/Ni.

9. The method as set forth in any of claims 1 to 8, wherein the metal catalyst used in step (b) is applied in a form of nanoparticles or a thin film.

10. The method as set forth in any of claims 1 to 9, wherein the metal catalyst used in step (b) is applied to a thickness of 50 nm or less.

11. The method as set forth in any of claims 1 to 10, wherein the metal catalyst used in step (b) is applied using any process selected from the group consisting of chemical vapor deposition, sputtering, e-beam evaporation, vacuum deposition, spin coating, and dipping.

12. The method as set forth in any of claims 1 to 11, wherein step (c) is conducted using a solid-liquid-solid process or a vapor-liquid-solid process.

13. The method as set forth in claim 12, wherein the solid-liquid-solid process is conducted by placing a substrate on which a glass template is disposed in a furnace and then heating the substrate while supplying a gas such that nanowires are formed by a wire source diffused from the substrate.

14. The method as set forth in claim 12, wherein the vapor-liquid-solid process is conducted by placing a substrate on which a glass template is disposed in a furnace and then heating the substrate while supplying a gas and a wire source to form nanowires.

15. The method as set forth in claim 13 or 14, wherein the gas is selected from the group consisting of Ar, N₂, He, and H₂.

16. The method as set forth in any of claims 13 to 15, wherein the wire source is selected from the group consisting of SiH₄, SiCl₄, and SiH₂Cl₂.

17. The method as set forth in any of claims 12 to 16, wherein the vapor-liquid-solid process is conducted at 370∼600°C under 1.0 bar (760 torr) or less, and the solid-liquid-solid process is conducted at 800∼1200°C under 1.0 bar (760 torr) or less.

18. The method as set forth in any of claims 1 to 17, wherein the forming of the nanowires in step (c) is conducted to form doped silicon nanowires through a doping process using a dopant.

19. The method as set forth in any of claims 1 to 18, wherein the forming of the nanowires in step (c) is conducted to form nanowires in a form of a superlattice structure or a hybrid structure through changing material or composition of the nanowires.

20. The method as set forth in any of claims 1 to 19, further comprising removing the glass template, after the forming of the silicon nanowires in step (c).

21. A device comprising silicon nanowires formed along pores in a porous glass template, wherein the electroluminescent device comprises a substrate 10, a first electrode layer 20, silicon nanowires 50 formed along pores in a porous glass template 30 doped with erbium or an erbium precursor, and a second electrode layer 40.

22. The device as set forth in claim 24, which is selected from the group consisting of electronic devices, sensors, photodetectors, light emitting diodes, laser diodes, electroluminescent devices, photoluminescent devices, and cathodoluminescent devices.

23. The device as set forth in claim 24 or 25, wherein the silicon nanowires are p-type, n-type, or p-n-type doped.

## Patentansprüche

1. Verfahren zur Herstellung von Siliziumnanodrähten, folgende Schritte umfassend:
(a) das Dotieren einer porösen Glasschablone mit einer Mehrzahl von langen, drahtförmigen Poren mit Erbium oder einem Erbiumpräkursor;
(b) das Anordnen der mit Erbium oder einem Erbiumpräkursor dotierten Glasschablone auf einem Substrat, auf dem eine Metallkatalysatorschicht ausgebildet ist; und
(c) das Ausbilden und Züchten von Siliziumnanodrähten entlang der Poren in der Glasschablone.

2. Verfahren nach Anspruch 1, wobei die poröse Glasschablone einen Durchmesser zwischen 1 nm und 1 mm aufweist sowie eine Höhe zwischen 100 nm und 1 mm.

3. Verfahren nach Anspruch 1 oder 2, wobei die Poren der porösen Glasschablone einen Durchmesser zwischen 1 und 100 nm aufweisen und in Intervallen zwischen 2 nm und 1 µm ausgebildet sind.

4. Verfahren nach einem der Ansprüche 1 bis 3, wobei das Dotieren mit Erbium oder einem Erbiumpräkursor in Schritt (a) unter Verwendung eines Prozesses ausgeführt wird, der aus der Gruppe ausgewählt wird, die folgendes umfasst: Ionenimplantation, elektrochemische Abscheidung, Aufschleuderdotierung, chemische Abscheidung, Sputtern, Laserablation, Kopräzipitation, ein Nassverfahren und ein Sol-Gel-Verfahren.

5. Verfahren nach einem der Ansprüche 1 bis 4, wobei es sich bei dem in Schritt (a) verwendeten Erbiumpräkursor um Erbiumchlorid (ErCl₃) handelt.

6. Verfahren nach einem der Ansprüche 1 bis 5, wobei dieses es ferner umfasst, dass die Glasschablone nach Schritt (a) einem reflektierenden Überzug ausgesetzt wird.

7. Verfahren nach einem der Ansprüche 1 bis 6, wobei das in Schritt (b) verwendete Substrat ein Siliziumsubstrat oder ein mit Silizium überzogenes Glassubstrat ist.

8. Verfahren nach einem der Ansprüche 1 bis 7, wobei der in Schritt (b) verwendete Metallkatalysator ausgewählt wird aus der Gruppe, die folgendes umfasst: Au, Ni, Fe, Ag, Pd und Pd/Ni.

9. Verfahren nach einem der Ansprüche 1 bis 8, wobei der in Schritt (b) verwendete Metallkatalysator in Form von Nanopartikeln oder einer Dünnschicht aufgetragen wird.

10. Verfahren nach einem der Ansprüche 1 bis 9, wobei der in Schritt (b) verwendete Metallkatalysator bis auf eine Dicke von 50 nm oder weniger aufgetragen wird.

11. Verfahren nach einem der Ansprüche 1 bis 10, wobei der in Schritt (b) verwendete Metallkatalysator unter Verwendung eines Prozesses aufgetragen wird, der aus der Gruppe ausgewählt wird, die folgendes umfasst: chemische Dampfabscheidung, Sputtern, E-Strahl-Evaporation, Vakuumabscheidung, Aufschleudern und Tauchen.

12. Verfahren nach einem der Ansprüche 1 bis 11, wobei Schritt (c) unter Verwendung eines Feststoff-Flüssigkeit-Feststoff-Prozesses oder eines Dampf-Flüssigkeit-Feststoff-Prozesses ausgeführt wird.

13. Verfahren nach Anspruch 12, wobei der Feststoff-Flüssigkeit-Feststoff-Prozess ausgeführt wird, indem ein Substrat, auf dem sich eine Glasschablone befindet, in einem Ofen platziert wird, und wobei das Substrat danach erhitzt wird, während ein Gas zugeführt wird, so dass Nanodrähte gebildet werden durch eine von dem Substrat diffundierte Drahtquelle.

14. Verfahren nach Anspruch 12, wobei Dampf-Flüssigkeit-Feststoff-Prozess ausgeführt wird, indem ein Substrat, auf dem sich eine Glasschablone befindet, in einem Ofen platziert wird, und wobei das Substrat danach erhitzt wird, während ein Gas und eine Drahtquelle zugeführt werden, um Nanodrähte auszubilden.

15. Verfahren nach Anspruch 13 oder 14, wobei das Gas aus der Gruppe ausgewählt wird, die Ar, N₂, He und H₂ umfasst.

16. Verfahren nach einem der Ansprüche 13 bis 15, wobei die Drahtquelle aus der Gruppe ausgewählt wird, die SiH₄, SiCl₄ und SiH₂Cl₂ umfasst.

17. Verfahren nach einem der Ansprüche 12 bis 16, wobei der Dampf-Flüssigkeit-Feststoff-Prozess bei 370 ∼ 600 °C unter 1,0 bar (760 torr) oder weniger ausgeführt wird, und wobei der Feststoff-Flüssigkeit-Feststoff-Prozess bei 800 ∼ 1200 °C unter 1,0 bar (760 torr) oder weniger ausgeführt wird.

18. Verfahren nach einem der Ansprüche 1 bis 17, wobei das Ausbilden der Nanodrähte in Schritt (c) so ausgeführt wird, dass dotierte Nanodrähte durch einen Dotierungsprozess unter Verwendung eines Dotierstoffes ausgebildet werden.

19. Verfahren nach einem der Ansprüche 1 bis 18, wobei das Ausbilden der Nanodrähte in Schritt (c) so ausgeführt wird, dass Nanodrähte in Form einer Übergitterstruktur oder einer Hybridstruktur durch Anpassen des Materials oder der Zusammensetzung der Nanodrähte ausgebildet werden.

20. Verfahren nach einem der Ansprüche 1 bis 19, ferner umfassend das Entfernen der Glasschablone nach dem Ausbilden der Siliziumnanodrähte in Schritt (c).

21. Vorrichtung, die Siliziumnanodrähte umfasst, die entlang Poren in einer porösen Glasschablone ausgebildet sind, wobei die Elektrolumineszenzvorrichtung ein Substrat 10, eine erste Elektrodenschicht 20, Siliziumnanodrähte 50, die entlang den Poren in einer porösen Glasschablone 30, die mit Erbium oder einem Erbiumpräkursor dotiert ist, ausgebildet sind, und eine zweite Elektrodenschicht 40 umfasst.

22. Vorrichtung nach Anspruch 21, die aus der Gruppe ausgewählt wird, die folgendes umfasst: elektronische Vorrichtungen, Sensoren, Photodetektoren, Lumineszenzdioden, Laserdioden, Elektrolumineszenzvorrichtungen, Photolumineszenzvorrichtungen und Kathodolumineszenzvorrichtungen.

23. Vorrichtung nach Anspruch 21 oder 22, wobei die Siliziumnanodrähte p-Typ-, n-Typ- oder p-n-Typ-dotiert sind.

## Revendications

1. Procédé de fabrication de nanofils de silicium, comprenant les étapes consistant à :
(a) doper un modèle de verre poreux ayant une pluralité de pores en forme de fils longs avec de l'erbium ou un précurseur de l'erbium ;
(b) placer le modèle de verre dopé avec de l'erbium ou le précurseur de l'erbium sur un substrat sur lequel une couche de catalyseur métallique est formée ; et
(c) former et faire croître des nanofils de silicium le long des pores dans le modèle de verre.

2. Procédé selon la revendication 1, dans lequel le modèle de verre poreux a un diamètre compris entre 1 nm et 1 mm et une hauteur comprise entre 100 nm et 1 mm.

3. Procédé selon l'une quelconque des revendications 1 et 2, dans lequel les pores du modèle de verre poreux ont un diamètre compris entre 1 et 100 nm, et sont formés à des intervalles compris entre 2 nm et 1 µm.

4. Procédé selon l'une quelconque des revendications 1 à 3, dans lequel le dopage avec l'erbium ou le précurseur de l'erbium à l'étape (a) est effectué en utilisant tout procédé choisi dans le groupe constitué par une implantation ionique, dépôt électrochimique, dopage par rotation, dépôt chimique, pulvérisation cathodique, ablation laser, coprécipitation, procédé par voie humide, et procédé sol-gel.

5. Procédé selon l'une quelconque des revendications 1 à 4, dans lequel le précurseur de l'erbium utilisé à l'étape (a) est du chlorure d'erbium (ErCl₃).

6. Procédé selon l'une quelconque des revendications 1 à 5, comprenant en outre l'étape consistant à soumettre une surface du modèle de verre à un revêtement réfléchissant, après l'étape (a).

7. Procédé selon l'une quelconque des revendications 1 à 6, dans lequel le substrat utilisé à l'étape (b) est un substrat de silicium ou un substrat de verre recouvert de silicium.

8. Procédé selon l'une quelconque des revendications 1 à 7, dans lequel le catalyseur métallique utilisé à l'étape (b) est choisi dans le groupe constitué d'Au, Ni, Fe, Ag, Pd et Pd/Ni.

9. Procédé selon l'une quelconque des revendications 1 à 8, dans lequel le catalyseur métallique utilisé à l'étape (b) est appliqué sous la forme de nanoparticules ou de film mince.

10. Procédé selon l'une quelconque des revendications 1 à 9, dans lequel le catalyseur métallique utilisé à l'étape (b) est appliqué sur une épaisseur inférieure ou égale à 50 nm.

11. Procédé selon l'une quelconque des revendications 1 à 10, dans lequel le catalyseur métallique utilisé à l'étape (b) est appliqué en utilisant tout procédé choisi dans le groupe constitué par un dépôt chimique en phase vapeur, pulvérisation cathodique, évaporation par faisceau d'électrons, dépôt sous vide, dépôt à la tournette, et immersion.

12. Procédé selon l'une quelconque des revendications 1 à 11, dans lequel l'étape (c) est effectuée en utilisant un procédé solide-liquide-solide ou un procédé vapeur-liquide-solide.

13. Procédé selon la revendication 12, dans lequel le procédé solide-liquide-solide est réalisé en plaçant un substrat sur lequel un modèle de verre est placé dans un four puis en chauffant le substrat tout en fournissant un gaz de sorte que les nanofils sont constitués par une source de fil diffusée à partir du substrat.

14. Procédé selon la revendication 12, dans lequel le procédé vapeur-liquide-solide est réalisé en plaçant un substrat sur lequel un modèle de verre est placé dans un four puis en chauffant le substrat tout en fournissant un gaz et une source de fil pour former des nanofils.

15. Procédé selon la revendication 13 ou 14, dans lequel le gaz est choisi dans le groupe constitué par Ar, N₂, He, et H₂.

16. Procédé selon l'une quelconque des revendications 13 à 15, dans lequel la source de fil est choisie dans le groupe constitué par de SiH₄, SiCl₄, et SiH₂Cl₂.

17. Procédé selon l'une quelconque des revendications 12 à 16, dans lequel le procédé vapeur-liquide-solide est effectué à 370∼600 °C sous 1,0 bar (760 torrs) ou moins, et le procédé solide-liquide-solide est effectué à 800∼1 200 °C sous 1,0 bar (760 torrs) ou moins.

18. Procédé selon l'une quelconque des revendications 1 à 17, dans lequel la formation des nanofils à l'étape (c) est réalisée pour former des nanofils de silicium dopé par un processus de dopage à l'aide d'un dopant.

19. Procédé selon l'une quelconque des revendications 1 à 18, dans lequel la formation des nanofils à l'étape (c) est réalisée pour former des nanofils dans une forme de structure de super-réseau ou une structure hybride en changeant le matériau ou la composition des nanofils.

20. Procédé selon l'une quelconque des revendications 1 à 19, comprenant en outre l'étape consistant à retirer le modèle de verre, après la formation des nanofils de silicium à l'étape (c).

21. Dispositif comprenant des nanofils de silicium formés le long de pores dans un modèle de verre poreux, dans lequel le dispositif électroluminescent comprend un substrat 10, une première couche d'électrode 20, des nanofils de silicium 50 formés le long de pores dans un modèle de verre poreux 30 dopé à l'erbium ou un précurseur de l'erbium, et une seconde couche d'électrode 40.

22. Dispositif selon la revendication 21, choisi dans le groupe constitué par des dispositifs électroniques, capteurs, photodétecteurs, diodes électroluminescentes, diodes laser, dispositifs électroluminescents, dispositifs photoluminescents et dispositifs cathodoluminescents.

23. Dispositif selon la revendication 21 ou 22, dans lequel les nanofils de silicium sont dopés de type p, de type n ou de type p-n.
